# EUROPÄISCHE PATENTSCHRIFT

(11) **EP 2 059 746 B1**
(45) Veröffentlichungstag und Bekanntmachung des Hinweises auf die Patenterteilung: **16.12.2009**
(21) Anmeldenummer: 07802768.7
(22) Anmeldetag: 21.08.2007
(51) Int. Cl.: F25D 23/06

(54) **KABELDURCHFÜHRUNG**
CABLE BUSHING
TRAVERSÉE DE CÂBLE

(30) Priorität: 29.08.2006 DE 202006013230 U
(43) Veröffentlichungstag der Anmeldung: 20.05.2009
(73) Patentinhaber: BSH Bosch und Siemens Hausgeräte GmbH, 81739 München (DE)
(72) Erfinder: EICHLER, Martin, 89522 Heidenheim (DE); SCHMIDT, Rudolf, 89537 Giengen (DE)
(86) Internationale Anmeldenummer: PCT/EP2007/058693
(87) Internationale Veröffentlichungsnummer: WO 2008/025702

(56) Entgegenhaltungen:
- WO-A-2004/075366
- US-A- 4 809 937

## Beschreibung

Die vorliegende Erfindung betrifft eine Kabeldurchführung zum dichten Führen eines Kabels, einer Rohrleitung oder dergleichen durch eine Wand. Ein Einsatzgebiet derartiger Durchführungen ist zum Beispiel der Kältegerätebau. Das Gehäuse eines Haushaltskältegerätes hat im Allgemeinen eine feste Außenwand und eine ein Lagerfach begrenzende Innenwand, und ein Zwischenraum zwischen Außen- und Innenwand ist durch Expansion eines Schaumstoffmaterials aufgefüllt. Leitungen, die Innen- und Außenwand und die Schaumstoffschicht kreuzen, müssen an Innen- und Außenwand zuverlässig abgedichtet sein, um ein Austreten des Schaums zu verhindern.

Ein möglicher Ansatz hierfür ist eine Labyrinthdichtung, bei der die durchzuführende Leitung durch einen kurvenreichen Kanal geführt ist, dessen Länge und Querschnitt so bemessen sind, dass in den Kanal eindringender Schaum darin abbindet und verfestigt, bevor er das gegenüberliegende Kanalende erreicht. Ein inhärenter Nachteil dieses Ansatzes ist der Platzbedarf des Kanals und die Schwierigkeit, das Kabel selbst durch den Kanal zu führen. Ein einfacherer Ansatz ist, in einer Wandöffnung eine flexible Dichtlippe anzubringen, die eine Öffnung aufweist, durch die das Kabel geführt ist, wobei es die Öffnung elastisch aufdehnt. Eine solche flexible Dichtlippe hat jedoch nur eine begrenzte Druckbelastbarkeit, und da sie nicht in der Lage ist, das Kabel zu fixieren, sind Undichtigkeiten aufgrund einer Verschiebung des Kabels nicht völlig ausgeschlossen. Keiner der beiden Ansätze ermöglicht die Montage eines Kabels, das ein im Vergleich zum Kabeldurchmesser verdicktes Kopfstück wie etwa einen Steckverbinder, einen Sensor oder eine andere Art von elektrischem Verbraucher trägt. Der hierfür erforderliche freie Querschnitt der Labyrinthdichtung würde eine Dichtwirkung für den Schaum unmöglich machen, und im Falle einer flexiblen Dichtlippe ist nicht gewährleistet, dass nach Durchgang des Kopfstückes die Dichtlippe das Kabel noch dicht umschließt.

Eine Kabeldurchführung gemäß dem Oberbegriff des Anspruchs 1 ist aus WO 2004075366 bekannt.

Aufgabe der Erfindung ist, eine Kabeldurchführung zu schaffen, die es ermöglicht, Kabel mitsamt einem verdickten Kopfstück durch eine Wandöffnung hindurchzuführen und dennoch eine sichere Abdichtung der Wandöffnung zu gewährleisten.

Die Aufgabe wird gelöst durch eine Kabeldurchführung mit einer in einer Wand gebildeten, von einer ersten Hülse umgebenen Öffnung, wobei die Hülse auf wenigstens einem Teil ihrer Länge mit einem randoffenen ersten Schlitz versehen ist, sowie mit einem Deckel, der eine in die erste Hülse eingreifende zweite Hülse trägt, die auf wenigstens einem Teil ihrer Länge mit einem randoffenen zweiten Schlitz versehen ist, wobei ein Überlappungsbereich der zwei Schlitze von einem durch die Öffnung verlaufenden Kabel ausgefüllt ist.

Diese Kabeldurchführung erlaubt die Montage eines Kabels mitsamt einem daran befestigten Kopfstück, indem die erste Hülse weit genug bemessen ist, um Kopfstück und Kabel hindurchzuführen, während die Breite des ersten Schlitzes nur ausreicht, um das Kabel darin - vorzugsweise unter Klemmung - aufzunehmen. Durch Aufsetzen des Deckels und Einführen der zweiten Hülse in die erste Hülse wird der Durchgang der ersten Hülse verschlossen, und der erste Schlitz wird verdeckt, soweit er nicht von dem Kabel ausgefüllt ist, so dass anschließend die Wandöffnung dicht ist.

Wenn sich ein Medium wie etwa Schaum, gegen das abgedichtet werden soll, auf derjenigen Seite der Wand befindet, von der aus der zweite Schlitz in den ersten eingeführt ist, ist der Deckel durch den Druck dieses Mediums in seiner Position gesichert. Wenn das Medium sich auf der entgegengesetzten Seite der Wand befindet, ist zur Sicherung vorzugsweise die zweite Hülse in der ersten Hülse verrastet.

Zur Verrastung kann die zweite Hülse an ihrem von dem Deckel abgewandten Rand einen Rastvorsprung tragen, der einen von dem Deckel abgewandten Rand der ersten Hülse hintergreift.

Um das Einführen in die erste Hülse und insbesondere die Verrastung zu erleichtern, kann die zweite Hülse eine Mehrzahl von über ihren Umfang verteilten Schlitzen aufweisen. Von diesen Schlitzen ist im Allgemeinen einer der oben erwähnte zweite Schlitz, durch den das Kabel verläuft.

Vorzugsweise füllt die zweite Hülse den freien Querschnitt der ersten Hülse aus, so dass ein Medium, gegen das abgedichtet werden soll, nicht zwischen die Hülsen eindringen kann.

Vorzugsweise ist die oben erwähnte Wand Teil eines Formteiles, das seinerseits in einer Wandöffnung einer Innenverkleidung oder einer Außenverkleidung eines Kältegerätes montierbar ist. Ein solches Formteil kann bequem beispielsweise im Spritzguss gefertigt werden. Die erfindungsgemäße Kabeldurchführung ist dank der Realisierung in einem Formteil an Wandöffnungen beliebiger Wände anwendbar, wobei die einzige Anforderung, die diese Wände erfüllen müssen, ist, dass das Formteil an ihnen befestigbar sein muss.

Um Undichtigkeiten zwischen dem Formteil und der es umgebenden Wand zu verhindern, ist das Formteil vorzugsweise mit einer umlaufenden Dichtlippe versehen, die im Falle der Montage der Kabeldurchführung an der Innen- und/oder Außenverkleidung eines Kältegerätes verhindert, dass das in flüssigen Ausgangskomponenten verarbeitete Wärmeisolationsmaterial an der Montagestelle austritt.

Eine umlaufende Kabelhalterung erlaubt es, eventuelle Überlängen des Kabels übersichtlich unterzubringen.

Einer bevorzugten Weiterbildung zufolge ist das Formteil als ein an einer Seite offener Hohlkörper ausgebildet, und der Deckel ist bemessen, um die offene Seite des Hohlkörpers zu verschließen. So kann das Kopfstück des Kabels im Hohlraum des Formteiles untergebracht und anschließend der Hohlraum mit dem Deckel verschlossen werden.

Zur Befestigung und/oder Lagefixierung des Deckels an dem Hohlkörper trägt der Deckel vorzugsweise einen im Kontakt mit Seitenwänden des Hohlkörpers in dessen Inneres eingreifenden umlaufenden Steg.

Vorzugsweise ist der Deckel durch ein Gelenk in ein fest mit der zweiten Hülse verbundenes Basisteil und eine gegen das Basisteil schwenkbare Klappe gegliedert. Indem die Klappe aufgeschwenkt werden kann, ist ein Zugriff auf das Innere des Formteiles, beispielsweise um das darin untergebrachte Kopfstück zu reparieren, möglich.

Um die Gelenkigkeit des Deckels nicht zu beeinträchtigen, ist der oben erwähnte Steg zweckmäßigerweise in Höhe des Gelenkes unterbrochen.

Insbesondere kann die Kabeldurchführung dazu dienen, in dem Hohlkörper einen Temperaturfühler unterzubringen, der beispielsweise bei einem Kältegerät für die Temperaturregelung von dessen Innenraum dienen kann.

Weitere Merkmale der Erfindung ergeben sich aus der nachfolgenden Beschreibung von Ausführungsbeispielen unter Bezugnahme auf die beigefügten Figuren. Es zeigen:
- Fig. 1: eine perspektivische Ansicht eines Formteiles, das einen ersten Teil der erfindungsgemäßen Kabeldurchführung bildet;
- Fig. 2: eine Draufsicht auf die konkave Seite des Formteiles der Fig. 1;
- Fig. 3: einen Schnitt entlang der in Fig. 2 mit G-G bezeichneten Ebene;
- Fig. 4: einen Schnitt entlang der in Fig. 2 mit J-J bezeichneten Ebene;
- Fig. 5: einen Schnitt entlang der in Fig. 2 mit H-H bezeichneten Ebene;
- Fig. 6: einen Schnitt entlang der in Fig. 2 mit C-C bezeichneten Ebene;
- Fig. 7: eine perspektivische Ansicht eines Deckels der Durchführung;
- Fig. 8: eine Draufsicht auf die dem Formteil zugewandte Seite des Deckels;
- Fig. 9: einen Schnitt entlang der in Fig. 8 mit B-B bezeichneten Ebene; und
- Fig. 10: das Formteil und den Deckel in zusammengefügtem Zustand in einem Schnitt entlang einer der Fig. 3 bzw. Fig. 8 entsprechenden Schnittebene.

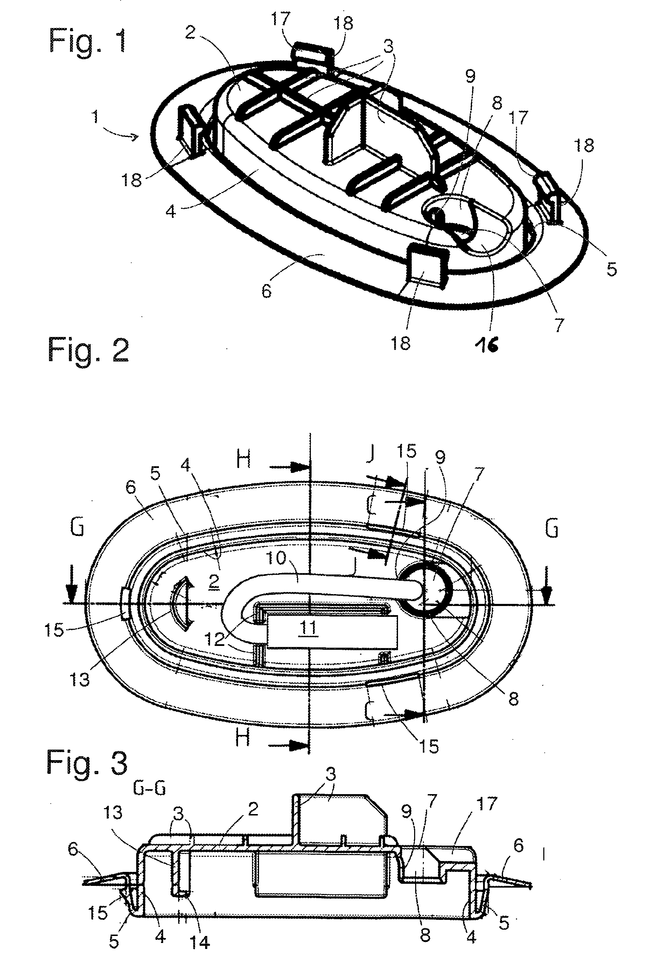

Fig. 1 ist eine perspektivische Ansicht eines Formteiles der erfindungsgemäßen Kabeldurchführung, das vorgesehen ist, um in einer Innenbehälterwand eines schaumisolierten Kältegerätes montiert zu werden. Die Figur zeigt einen Blick auf die der isolierenden Schaumschicht zugewandte Seite des Formkörpers 1. Der Formkörper umfasst eine im Umriss elliptische Grundplatte 2, von der mehrere, die Grundplatte 2 versteifende und den Formkörper 1 in der Schaumschicht verankernde Rippen 3 abstehen. Die Grundplatte 2 ist von einer umlaufenden, steifen Seitenwand 4 umgeben. Die Seitenwand 4 ist an ihrem in Fig. 1 nicht sichtbaren, von der Grundplatte 2 abgewandten Rand mit einer sie konzentrisch umgebenden Schürze 5 verbunden, die wiederum von einer flach kegelförmigen flexiblen Dichtlippe 6 umgeben ist.

Fig. 2 zeigt in einer Draufsicht einen Einblick in einen von der Grundplatte 2 und der Seitenwand 4 begrenzten Innenraum. In der Grundplatte 2 ist eine kreisrunde Öffnung 7 benachbart zu einem Längsende der Grundplatte 2 und gegen eine Längsmittelebene G-G versetzt gebildet. Die Öffnung 7 ist von einer in den Innenraum vorspringenden Hülse 8 eingefasst. In der Hülse 8 ist ein Schlitz 9 gebildet, der zu einem von der Grundplatte 2 abgewandten Rand der Hülse 8 hin offen ist. Fig. 2 zeigt ein Kabel 10, das sich durch die Öffnung 7 hindurch erstreckt, in den Schlitz 9 eingeschoben ist und mit einem Temperaturfühler 11 verbunden ist, der durch von der Grundplatte 2 in den Innenraum abstehende Stege 12 lagefixiert ist. An einem der Öffnung 7 entgegengesetzten Längsende der Grundplatte 2 ist eine in den Innenraum vorspringende Säule 13 geformt, die einen Rastvorsprung 14 trägt.

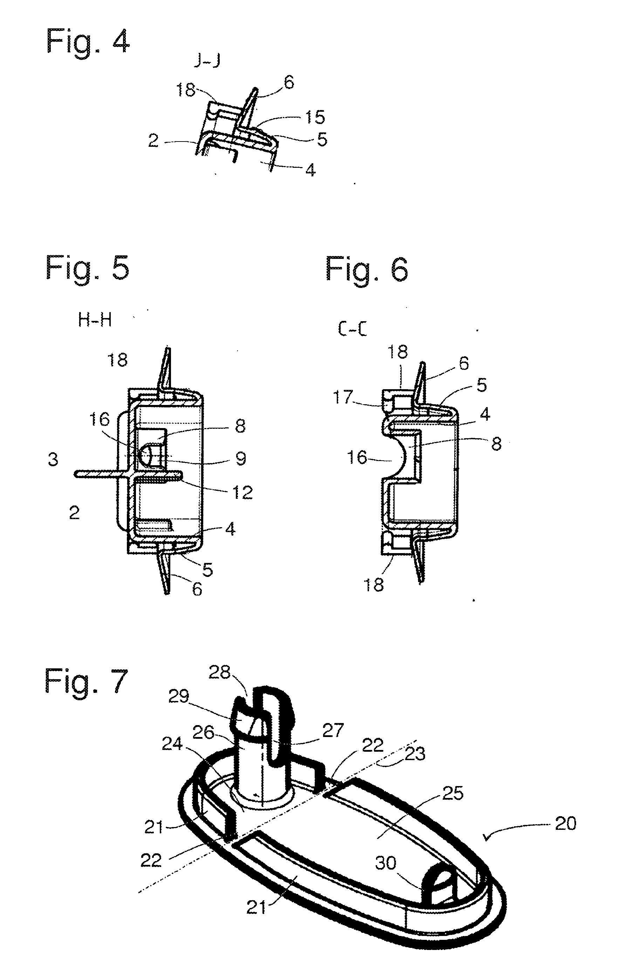

An der umlaufenden Schürze 5 sind, wie in den Schnitten der Figuren 3 und 4 zu erkennen, drei Rastnasen 15 verteilt. Beim Einführen des Formkörpers 1 in eine passend geformte Öffnung eines Kältegeräte-Innenbehälters oder einer anderen geeigneten Wand werden die Rastnasen 15 unter elastischer Verformung der Schürze 5 zunächst gegen die Seitenwand 4 gedrückt und rücken nach Passieren der Öffnung wieder aus, so dass die Innenbehälterwand zwischen den Rastnasen 15 einerseits und der elastisch verformten Dichtlippe 6 andererseits eingeklemmt ist. Der an der Innenbehälterwand anliegende äußere Rand der Dichtlippe 6 sorgt für Schaumdichtigkeit der Verbindung zwischen der Innenbehälterwand und dem Formkörper 1.

In den Figuren 1, 5 und 6 ist eine Einbuchtung 16 der Grundplatte 2 zu erkennen, die sich von einem dem Schlitz 9 gegenüberliegenden Randbereich der Öffnung 7 bis zu einem Rand der Grundplatte 2 erstreckt. Diese Einbuchtung 16 ermöglicht es, das Kabel 10 unter Vermeidung starker Krümmung durch die Öffnung 7 zu führen.

Vier von der Schürze 5 abstehende, jeweils einen der Seitenwand 4 zugewandten Vorsprung 17 tragende Arme 18 begrenzen zwischen sich und der Seitenwand 4 einen Kabelführungsweg, auf den das aus der Öffnung 7 austretende Kabel 10 ein oder mehrere Male um die Seitenwand 4 herumgeschlungen werden kann. Eine solche Anbringung des Kabels 10 ist zweckmäßig, wenn das Kabel 10 auf kurzem Weg durch die Wärme isolierende Schaumschicht hindurchgeführt ist, da der um die Seitenwand 4 gewickelte Abschnitt des Kabels im Wesentlichen der gleichen Temperatur ausgesetzt ist wie der Temperaturfühler 11 und diesen vor einer Verfälschung des Messwertes durch in dem Kabel 10 selbst durch die isolierende Schaumschicht hindurchgeleitete Wärme schützt.

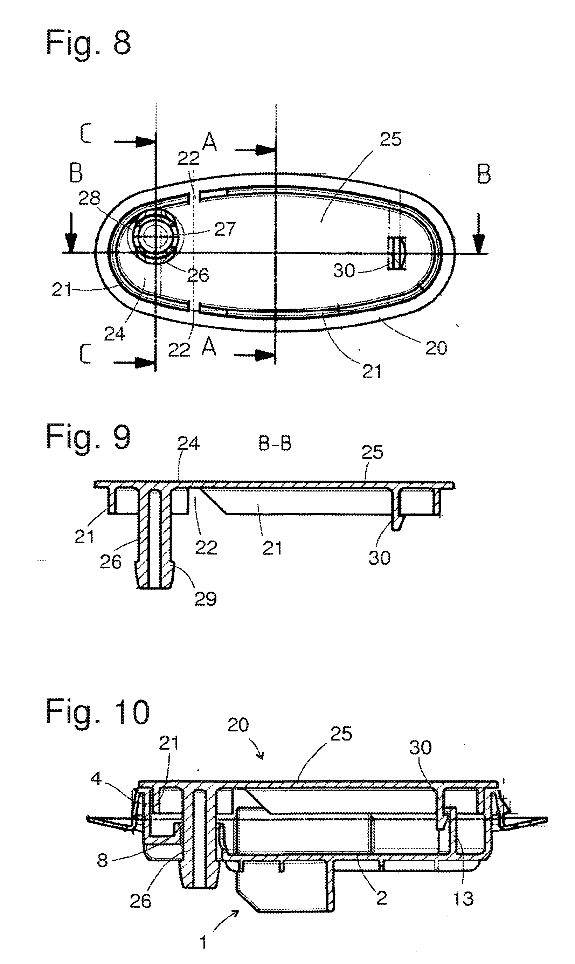

Fig. 7 zeigt in perspektivischer Ansicht einen Deckel 20, der vorgesehen ist, um an dem Formkörper 1 montiert zu werden und dessen inneren Hohlraum zu verschließen. Derselbe Deckel 20 ist in Fig. 8 in einer Draufsicht auf seine Innenseite und in Fig. 9 in einem Schnitt entlang der in Fig. 8 mit B-B bezeichneten Ebene zu sehen. Der aus einem flexiblen Kunststoffmaterial geformte Deckel 20 trägt an seiner dem Formkörper 1 zugewandten Seite einen umlaufenden Steg 21, der vorgesehen ist, um in reib- und formschlüssigem Kontakt mit den Seitenwänden 4 in den Innenraum des Formkörpers 1 einzugreifen. Der Steg 21 ist an zwei Stellen 22 unterbrochen, um eine Knicklinie 23 zu definieren, die den Deckel in ein Basisteil 24 und eine Klappe 25 teilt.

Das Basisteil 24 trägt eine kreisrunde Hülse 26, deren Durchmesser bemessen ist, um die Hülse 8 des Formkörpers 1 exakt auszufüllen, und in der zwei sich diametral gegenüberliegende, zu einem von dem Basisteil 24 abgewandten Rand der Hülse 26 hin offene Schlitze 27, 28 gebildet sind. Am von dem Basisteil 24 abgewandten Rand der Hülse 26 ist ferner ein Rastvorsprung 29 gebildet.

Die Klappe 25 ist mit einem Rasthaken 30 versehen.

Formkörper 1 und Deckel 20 werden zusammengefügt, indem die Hülse 26 des Deckels in die Hülse 8 des Formkörpers eingeschoben wird, bis der Rastvorsprung 29 die Hülse 8 vollständig passiert hat und an der Außenseite der Grundplatte 2 einhakt. Dieser zusammengefügte Zustand ist in Fig. 10 gezeigt. Die Länge der Schlitze 9, 27 ist so bemessen, dass eine Querschnittsfläche, auf der beide im verrasteten Zustand überlappen, exakt dem Querschnitt des durchgeführten Kabels 10 entspricht. Der Rasthaken 30 der Klappe 25 greift in montiertem Zustand hinter den Rastvorsprung 14 der Säule 13. Wenn in diesem Zustand die Gehäusewand des Kältegerätes ausgeschäumt wird, kann Schaum zwar ins Innere der Hülse 26 eindringen, er kann aber nicht am Kabel vorbei die (außerhalb der Schnittebene der Fig. 10 liegenden) Schlitze 9, 27 passieren. Wenn der Schaum abbindet und dabei das Innere der Hülse 26 ausfüllt, ist es nicht mehr möglich, die Verrastung der Hülsen 26, 8 aneinander zu lösen, und der Deckel 20 ist dauerhaft am Formkörper 1 verankert. Dennoch bleibt die Möglichkeit, den Deckel 20 zu öffnen, indem durch Ziehen an der Klappe 25 der Eingriff des Rasthakens 30 am Rastvorsprung 14 gelöst wird und die Klappe 25 aufgeschwenkt wird. So können im Bedarfsfall Reparaturarbeiten an dem über die offene Klappe 25 freiliegenden Temperaturfühler 11 vorgenommen werden.

## Patentansprüche

1. Eine Kabeldurchführung umfasst eine in einer Wand (2) gebildete, von einer ersten Hülse (8) umgebene Öffnung (7), wobei die erste Hülse (8) auf wenigstens einem Teil ihrer Länge mit einem randoffenen ersten Schlitz (9) versehen ist, sowie einen Deckel (20), **dardurch gekennzeichnet, dass** der Deckel eine in die erste Hülse (8) eingreifende zweite Hülse (26) trägt, die auf wenigstens einem Teil ihrer Länge mit einem randoffenen zweiten Schlitz (27) versehen ist und dass ein Überlappungsbereich der zwei Schlitze (9, 27) von einem durch die Öffnung (7) verlaufenden Kabel (10) ausgefüllt ist.

2. Kabeldurchführung nach Anspruch 1, **dadurch gekennzeichnet, dass** die zweite Hülse (26) in der ersten Hülse (8) verrastet ist.

3. Kabeldurchführung nach Anspruch 1, **dadurch gekennzeichnet, dass** die zweite Hülse (26) an ihrem von dem Deckel (20) abgewandten Rand einen Rastvorsprung (29) trägt, der einen von dem Deckel (20) abgewandten Rand der ersten Hülse (8) hintergreift.

4. Kabeldurchführung nach einem der vorhergehenden Ansprüche, **dadurch gekennzeichnet, dass** die zweite Hülse (26) eine Mehrzahl von über ihren Umfang verteilten Schlitzen (27, 28) aufweist.

5. Kabeldurchführung nach einem der vorhergehenden Ansprüche, **dadurch gekennzeichnet, dass** die zweite Hülse (26) den freien Querschnitt der ersten Hülse (8) ausfüllt.

6. Kabeldurchführung nach einem der vorhergehenden Ansprüche, **dadurch gekennzeichnet, dass** die Hülsen (8, 26) jeweils einen runden Querschnitt haben.

7. Kabeldurchführung nach einem der vorhergehenden Ansprüche, **dadurch gekennzeichnet, dass** die Wand (2) Teil eines seinerseits in einer Wandöffnung montierbaren Formteils (1) ist.

8. Kabeldurchführung nach Anspruch 7, **dadurch gekennzeichnet, dass** das Formteil (1) mit einer umlaufenden Dichtlippe (6) versehen ist.

9. Kabeldurchführung nach Anspruch 7 oder 8, **dadurch gekennzeichnet, dass** das Formteil (1) mit einer umlaufenden Kabelhalterung (5, 18) versehen ist.

10. Kabeldurchführung nach einem der Ansprüche 7 bis 9, **dadurch gekennzeichnet, dass** das Formteil (1) ein an einer Seite offener Hohlkörper ist und dass der Deckel (20) bemessen ist, um die offene Seite des Hohlkörpers (1) zu verschließen.

11. Kabeldurchführung nach Anspruch 10, **dadurch gekennzeichnet, dass** der Deckel (20) einen im Kontakt mit Seitenwänden (4) des Hohlkörpers (1) in dessen Inneres eingreifenden umlaufenden Steg (21) trägt.

12. Kabeldurchführung nach Anspruch 10, **dadurch gekennzeichnet, dass** der Deckel (20) durch ein Gelenk (23) in ein fest mit der zweiten Hülse (26) verbundenes Basisteil (24) und eine gegen das Basisteil (24) schwenkbare Klappe (25) gegliedert ist.

13. Kabeldurchführung nach Anspruch 11 und Anspruch 12, **dadurch gekennzeichnet, dass** der Steg (21) in Höhe des Gelenks (23) unterbrochen ist.

14. Kabeldurchführung nach einem der Ansprüche 10 bis 13, **dadurch gekennzeichnet, dass** in dem Hohlkörper (1) ein Temperaturfühler (11) untergebracht ist.

15. Kältegerät mit einem eine Außenverkleidung, eine Wärmeisolationsschicht und eine Innenverkleidung aufweisenden wärmeisolierendem Gehäuse, **dadurch gekennzeichnet, dass** die Außenverkleidung und/oder die Innenverkleidung mit einer Kabeldurchführung nach einem der Ansprüche 1 bis 14 ausgestattet ist.

## Claims

1. A cable bushing comprising an opening (7) which is formed in a wall (2) and surrounded by a first sleeve (8), wherein the first sleeve (8) is provided on at least a part of its length with a first slot (9) open at the edge, as well as a cover (20), **characterised in that** the cover carries a second sleeve (26), which engages in the first sleeve (8) and which is provided on at least a part of its length with a second slot (27) open at the edge and that an overlap region of the two slots (9, 27) is filled by a cable (10) running through the opening (7).

2. Cable bushing according to claim 1, **characterised in that** the second sleeve (26) is detented in the first sleeve (8).

3. Cable bushing according to claim 1, **characterised in that** the second sleeve (26) carries at its edge remote from the cover (20) a detent projection (29) engaging behind an edge of the first sleeve (8) remote from the cover (20).

4. Cable bushing according to any one of the preceding claims, **characterised in that** the second sleeve (26) has a plurality of slots (27, 28) distributed over its circumference.

5. Cable bushing according to any one of the preceding claims, **characterised in that** the second sleeve (26) fills out the free cross-section of the first sleeve (8).

6. Cable bushing according to any one of the preceding claims, **characterised in that** the sleeves (8, 26) each have a round cross-section.

7. Cable bushing according to any one of the preceding claims, **characterised in that** the wall (2) is part of a shaped part (1) itself mountable in a wall opening.

8. Cable bushing according to claim 7, **characterised in that** the shaped part (1) is provided with an encircling sealing lip (6).

9. Cable bushing according to claim 7 or 8, **characterised in that** the shaped part
(1) is provided with an encircling cable mount (5, 18).

10. Cable bushing according to any one of claims 7 to 9, **characterised in that** the shaped part (1) is a hollow body open at one side and that the cover (20) is dimensioned so as to close the open side of the hollow body (1).

11. Cable bushing according to claim 10, **characterised in that** the cover (20) carries an encircling web (21) in contact with side walls (4) of the hollow body (1) and engaging in the interior thereof.

12. Cable bushing according to claim 10, **characterised in that** the cover (20) is divided by a joint (23) into a base part (24) fixedly connected with the second sleeve (26) and a flap (25) pivotable relative to the base part (24).

13. Cable bushing according to claim 11 and claims 12, **characterised in that** the web (21) is interrupted at the level of the joint (23).

14. Cable bushing according to any one of claims 10 to 13, **characterised in that** a temperature sensor (11) is accommodated in the hollow body (1).

15. Refrigerating appliance with a thermally insulating housing having an outer cladding, a thermal insulation layer and an inner lining, **characterised in that** the outer cladding and/or the inner lining is or are equipped with a cable bushing according to any one of claims 1 to 14.

## Revendications

1. Une traversée de câble comprend une ouverture (7) formée dans une paroi (2) entourée par une première douille (8), la première douille (8) étant pourvue, sur au moins une partie de sa longueur, d'une première fente (9) ouverte sur un bord, et un couvercle (20), **caractérisée en ce que** le couvercle porte une seconde douille (26) s'engageant dans la première douille (8) qui est pourvue, sur au moins une partie de sa longueur, d'une seconde fente (27) ouverte sur un bord et **en ce qu'**une zone de chevauchement des deux fentes (9, 27) est remplie par un câble (10) s'étendant à travers l'ouverture (7).

2. Traversée de câble selon la revendication 1, **caractérisée en ce que** la seconde douille (26) est enclenchée dans la première douille (8).

3. Traversée de câble selon la revendication 1, **caractérisée en ce que** la seconde douille (26) porte, sur son bord éloigné du couvercle (20), une saillie d'encliquetage (29) qui s'engage derrière un bord de la première douille (8) éloigné du couvercle (20).

4. Traversée de câble selon l'une des revendications précédentes, **caractérisée en ce que** la seconde douille (26) est pourvue d'une pluralité de fentes (27, 28) réparties sur sa circonférence.

5. Traversée de câble selon l'une des revendications précédentes, **caractérisée en ce que** la seconde douille (26) remplit la section transversale libre de la première douille (8).

6. Traversée de câble selon l'une des revendications précédentes, **caractérisée en ce que** les douilles (8, 26) ont à chaque fois une section transversale ronde.

7. Traversée de câble selon l'une des revendications précédentes, **caractérisée en ce que** la paroi (2) fait partie d'un élément préformé (1) pouvant être monté pour sa part dans une ouverture de paroi.

8. Traversée de câble selon la revendication 7, **caractérisée en ce que** l'élément préformé (1) est pourvu d'une lèvre d'étanchéité périphérique (6).

9. Traversée de câble selon la revendication 7 ou 8, **caractérisée en ce que** l'élément préformé (1) est pourvu d'un support de câble périphérique (5, 18).

10. Traversée de câble selon l'une des revendications 7 à 9, **caractérisée en ce que** l'élément préformé (1) est un corps creux ouvert sur un côté et **en ce que** le couvercle (20) est dimensionné pour fermer le côté ouvert du corps creux (1).

11. Traversée de câble selon la revendication 10, **caractérisée en ce que** le couvercle (20) porte une âme périphérique (21) s'engageant à l'intérieur du corps creux (1) en contact avec ses parois latérales (4).

12. Traversée de câble selon la revendication 10, **caractérisée en ce que** le couvercle (20) est divisé par une articulation (23) en une partie de base (24) reliée fixement à la seconde douille (26) et un volet (25) pivotant par rapport à la partie de base (24).

13. Traversée de câble selon la revendication 11 et la revendication 12, **caractérisée en ce que** l'âme (21) est interrompue à la hauteur de l'articulation (23).

14. Traversée de câble selon l'une des revendications 10 à 13, **caractérisée en ce qu'**une sonde de température (11) est logée dans le corps creux (1).

15. Appareil frigorifique comprenant un boîtier calorifuge pourvu d'un revêtement extérieur, d'une couche d'isolation thermique et d'un revêtement intérieur, **caractérisé en ce que** le revêtement extérieur et/ou le revêtement intérieur est/sont équipé/s d'une traversée de câble selon l'une des revendications 1 à 14.
